# EUROPEAN PATENT APPLICATION

(11) **EP 2 458 651 A2**
(43) Date of publication of application: **30.05.2012**
(21) Application number: 11191019.6
(22) Date of filing: 28.11.2011
(51) Int. Cl.: H01L 31/18, G01R 31/26

(54) **Laser apparatus and method for manufacturing a solar cell module using the same**

(30) Priority: 26.11.2010 KR 20100118724
(71) Applicant: Samsung SDI Co., Ltd., Gyeonggi-do (KR); Samsung Electronics Co., Ltd, Gyeonggi-do (KR)
(72) Inventor: Kang, Ku-Hyun, Gyeonggi-do (KR)
(74) Representative: Mounteney, Simon James

(57) **Abstract**

A method for manufacturing a solar cell module includes forming a first electrode on a first surface of a substrate; forming a semiconductor layer on the first electrode; forming a second electrode on the semiconductor layer; inverting the substrate with the first electrode, semiconductor layer and second electrode formed thereon, and then, positioning the inverted substrate on a plurality of supports; patterning the second electrode and the semiconductor layer while the inverted substrate is on the supports by irradiating a laser on a second surface of the substrate to form a plurality of solar cells, wherein the second surface of the substrate is opposite the first surface of the substrate; identifying defective solar cells by using the supports; and repairing the defective solar cells by using the supports.

## Description

### BACKGROUND

### Technical Field

The present invention relates to a laser apparatus and a method for manufacturing a solar cell module using the same.

### Discussion of the Related Art

A solar cell is a photoelectric conversion device that transforms solar energy into electrical energy, and has been drawing much attention as an infinite, yet pollution-free next-generation energy resource.

A solar cell is basically a diode configured of a PN junction, except that the solar cell's diode is exposed to light which yields a photocurrent in addition to the diode current. Solar cells may be classified according to a material they use as a light absorbing layer.

For example, a solar cell that uses silicon as the light absorbing layer may be classified as a crystalline silicon solar cell or a thin film solar cell. A crystalline silicon solar cell may be classified according to its crystallinity (e.g., single crystal or polycrystalline). A thin film solar cell may be classified according to its photovoltaic material (e.g., crystalline or amorphous).

Classes of solar cells belonging to the group of thin film solar cells may include a copper indium gallium selenide (CIGS) solar cell, a cadmium telluride (CdTe) solar cell, a III-V group semiconductor solar cell, a dye-sensitized solar cell, and an organic solar cell.

In a solar cell module manufacturing process, a plurality of solar cells is patterned to be connected in series to form a desired voltage of the module. The patterning involves a laser patterning process, and then, an inspection process is performed in which inter-cell insulation resistance characteristics are measured to determine whether or not a defective cell is present. Subsequently, defective cells, e.g., those having poor insulation characteristics, are repaired.

As can be gleaned, the steps involved in the manufacture of a solar cell module can be time consuming. Therefore, there is a need to quicken the solar cell module manufacturing process.

### SUMMARY

An embodiment of the present invention provides a method for manufacturing a solar cell module, including: forming a first electrode on a first surface of a substrate; forming a semiconductor layer on the first electrode; forming a second electrode on the semiconductor layer; inverting the substrate with the first electrode, semiconductor layer and second electrode formed thereon, and then, positioning the inverted substrate on a plurality of supports; patterning the second electrode and the semiconductor layer while the inverted substrate is on the supports by irradiating a laser on a second surface of the substrate to form a plurality of solar cells, wherein the second surface of the substrate is opposite the first surface of the substrate; identifying defective solar cells by using the supports; and repairing the defective solar cells by using the supports.

The supports may be included on a supporting plate, and wherein a first support includes first and second vertical supporting members vertically extending from the supporting plate and a horizontal supporting member having a first end connected to the first vertical supporting member and a second end connected to the second vertical support member.

The first support may be in contact with a surface of the second electrode of a solar cell.

The defective solar cells may be identiifed by measuring a resistance of each solar cell.

The resistance measurement of a solar cell is made by using the support in contact with that solar cell and the support in contact with an adjacent solar cell.

A solar cell is defective if its measured resistance is 500Ω or less.

The defective cells may be repaired by applying a current or voltage to the supports contacting the defective cells.

The the defective cells may be repaired by applying a voltage of 3V to 12V to the supports contacting the defective cells.

The the defective cells may be repaired by applying a current of 0.05A to 0.3A to the supports contacting the defective cells for 1 second to 5 seconds.

The method for manufacturing a solar cell module may further include forming a first groove in the first electrode by patterning the first electrode after forming the first electrode.

The method for manufacturing a solar cell module may further include forming a second groove in the semiconductor layer by patterning the semiconductor layer after forming the semiconductor layer.

The supports on the supporting plate may be configured such that a first support includes first and second vertical supporting members vertically extending from the supporting plate and first and second horizontal supporting members, each horizontal supporting member having a first end connected to the first vertical supporting member and a second end connected to the second vertical supporting member, and a groove may be disposed between the first and second horizontal supporting members.

The identification of the defective solar cells may be performed immediately after the patterning of the second electrode and the semiconductor layer. The defective solar cells may be repaired immediately after they are identified.

An embodiment of the present invention provides a laser apparatus, including: a laser generator; and an inspecting and repairing unit, wherein the inspecting and repairing unit includes a supporting plate, and a plurality of supports disposed on the supporting plate, wherein a support includes first and second vertical supporting members vertically extending from the supporting plate and a horizontal supporting member connecting the vertical supporting members, and wherien the plurality of supports receive a current or voltage through the supporting plate.

The horizontal supporting member may include a first horizontal supporting member and a second horizontal supporting member with a space formed therebetween.

The laser apparatus may include a space between the laser generator and the supports, the space being large enough to accommodate a solar cell module therebetween.

According to a first aspect of the invention, there is provided a method for manufacturing a solar cell module, comprising: forming a first electrode layer on a first surface of a substrate; forming a semiconductor layer on the first electrode; forming a second electrode layer on the semiconductor layer; inverting the substrate with the first electrode layer, semiconductor layer and second electrode layer formed thereon, and then, positioning the inverted substrate on a plurality of supports; patterning the second electrode layer and the semiconductor layer while the inverted substrate is on the supports by irradiating a laser on a second surface of the substrate to form a plurality of solar cells, wherein the second surface of the substrate is opposite the first surface of the substrate. Preferred features of this aspect are set out in claims 2 to 11.

According to a second aspect of the invention, there is provided a laser apparatus as set out in claim 12. Preferred features of this aspect are set out in claims 13 and 14.

### BRIEF DESCRIPTION OF THE DRAWINGS

FIG. 1 is a layout showing a solar cell module according to an embodiment of the present invention;
FIG. 2 is a cross-sectional view taken along line II-II of FIG. 1;
FIGS. 3 to 6 are diagrams sequentially showing a method for manufacturing a solar cell module according to an embodiment of the present invention;
FIG. 7 is a diagram showing a support structure according to an embodiment of the present invention; and
FIG. 8 is a diagram showing a support structure according to an embodiment of the present invention.

### DETAILED DESCRIPTION OF EXEMPLARY EMBODIMENTS

Exemplary embodiments of the present invention will be described more fully hereinafter with reference to the accompanying drawings.

However, the present invention may be embodied in various different ways and should not be construed as limited to the exemplary embodiments described herein.

In the drawings, the shapes and sizes of elements may be exaggerated for clarity.

It will be understood that when an element such as a layer, film, region, or substrate is referred to as being "on" another element, it can be directly on the other element or intervening elements may also be present.

Like reference numerals may designate like elements throughout the specification and drawings.

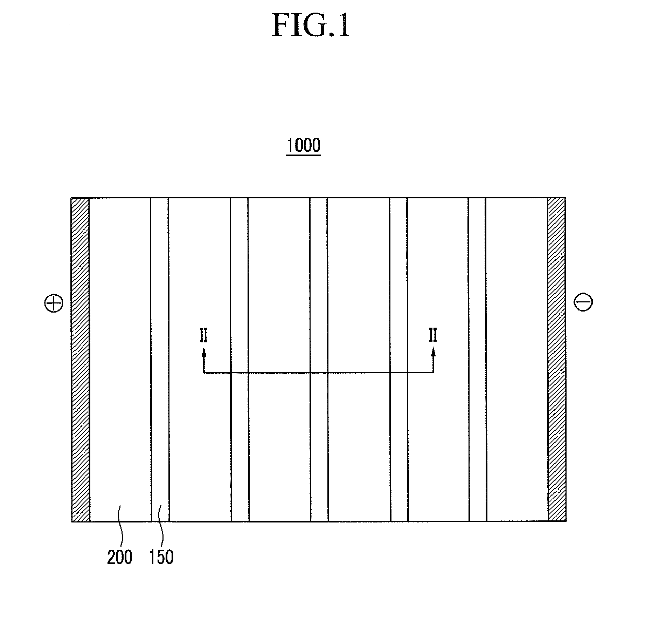

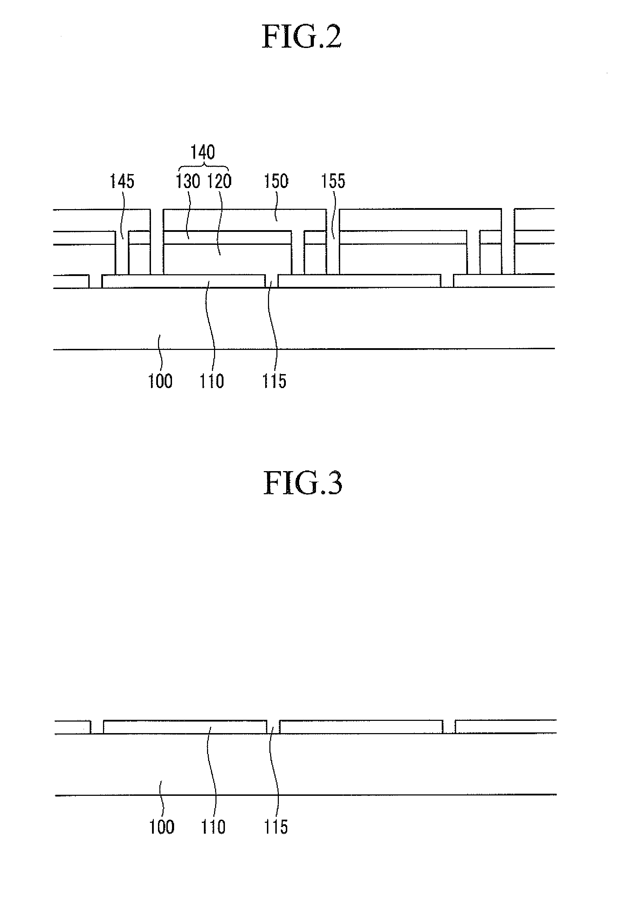

FIG. 1 is a layout showing a solar cell module according to an embodiment of the present invention and FIG. 2 is a cross-sectional view taken along line II-II of FIG. 1.

Referring to FIGS. 1 and 2, a solar cell module 1000 is configured to include a plurality of solar cells 200. Each cell 200 is configured to include a first electrode 110, a second electrode 150, and a semiconductor layer 140 formed between the first electrode 110 and the second electrode 150. In the solar cell module 1000, the second electrode 150 and the first electrode 110 in adjacent solar cells 200 are connected are connected to each other.

The first electrode 110 is formed on a substrate 100 composed of glass or plastic and a first groove 115 penetrating through the first electrode 110 is formed on the first electrode 110.

The first electrode 110 may be made of a transparent electrode containing material such as SnO2, ZnO:A1, ZnO:B, indium tin oxide (ITO), indium zinc oxide (IZO), or the like.

The semiconductor layer 140 filled in the first groove 115 is formed on the first electrode 110 and a second groove 145 penetrating through the semiconductor layer 140 is formed thereon.

A P layer 120 having a p-type (positive type) impurity and an N-layer 130 having an n-type (negative type) impurity are sequentially stacked in the semiconductor layer 140.

The P layer 120 may be made of any one of a boron doped amorphous silicon (a-Si:H), an amorphous silicon carbide (a-SiC:H), and a fine crystalline silicon (mc-Si:H). The N layer 130 may be made of an amorphous silicon (a-Si:H) or a fine crystalline silicon (mc-Si:H). In this case, an I (intrinsic) layer made of an amorphous material may be further provided between the P layer 120 and the N layer 130.

In addition, the P layer 120 may be made of CuInSe2(CIS) or CuInGaSe2(CIGS) and the N layer 130 may be made of CdS.

According to an embodiment of the present invention, the semiconductor layer 140 may include a stacked structure in which a unit configured of the P layer, the I layer, and the N layer is repeated twice or more. Silicon oxide or zinc oxide may be included between the units.

The second electrode 150 filling the second groove 145 is formed on the semiconductor layer 140 and a third groove 155 penetrating through the second electrode 150 and the semiconductor layer 140 is formed thereon.

The second electrode 150 is made of a low resistance metal such as silver (Ag).

The first groove 115 serves to insulate the first electrode 110 and the third groove 155 serves to insulate the adjacent solar cells 200 in the solar cell module 1000 having a plurality of solar cells 200. The second electrode 150 and the first electrode 110 of the adjacent cells 200 are electrically connected to each other through the second groove 145.

FIGS. 3 to 6 are diagrams sequentially showing a method for manufacturing a solar cell module according to an embodiment of the present invention.

Referring to FIGS. 3 to 6, the first electrode 110 is stacked on the substrate 100 by using a sputtering method, or the like. Further, the first groove 115 is formed by patterning the first electrode 110 using a laser scribing method or a mechanical scribing method. In other words, the first electrode for each cell 200 is formed by patterning a first electrode layer.

Then, the semiconductor layer 140 to fill the first groove 115 is formed on the first electrode 110. Further, the second groove 145 is formed by patterning the semiconductor layer 140 using a laser scribing method or a mechanical scribing method. In other words, the semiconductor layer region for each cell 200 is formed by patterning a semiconductor layer.

Then, the second electrode 150 to fill the second groove 145 is formed on the semiconductor layer 140. The third groove 155 is formed by patterning the second electrode 150 and the semiconductor layer 140 by using a laser scribing method, thereby forming the plurality of cells 200. In other words, the second electrode for each cell 200 is formed by patterning a second electrode layer. In this embodiment, the second electrode for one cell contacts the first electrode of an adjacent cell via the corresponding second groove 145.

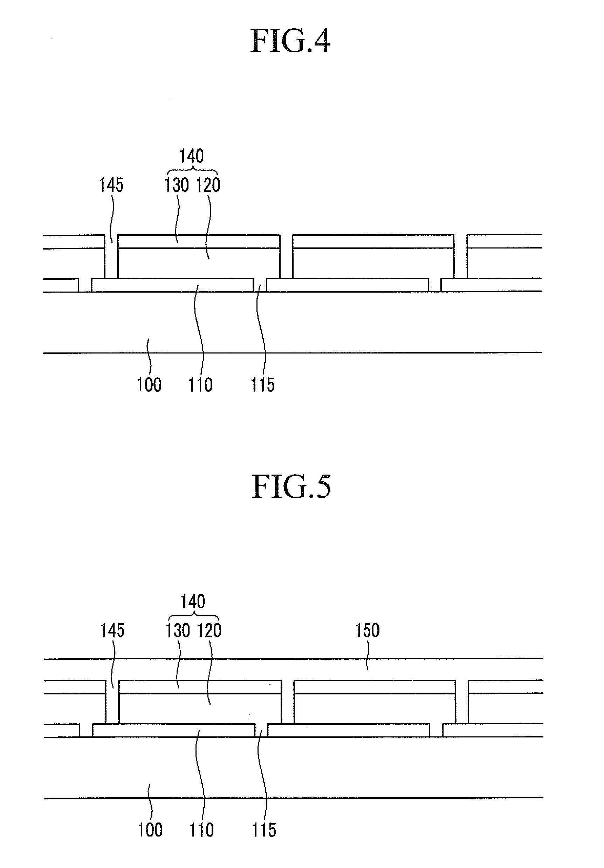

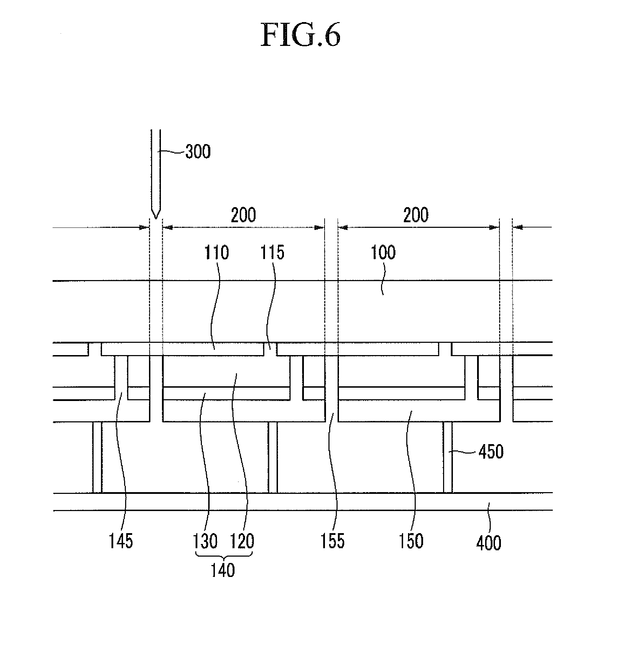

The formation of the third groove 155 will now be described in more detail. For example, after the second electrode 150 is formed on the semiconductor layer 140 as shown FIG. 5, the resultant structure is inverted as shown in FIG. 6, and then, positioned on a support 450 supporting the resultant structure to prevent the structure from sagging. In this arrangement, particles may be easily removed when a laser patterning is performed. Then, a laser beam from a laser generator 300 on the top portion of the substrate 100 is emitted to the substrate 100, thereby forming the third groove 155.

The support 450 is formed on a supporting plate 400 and contacts the second electrode 150 of each cell 200.

After the third groove 155 is formed by performing the laser patterning, the resistance of each cell 200 is measured by using the support 450 that is in contact with the second electrode 150 of each cell 200 to identify defective cells. The defective cells are repaired by applying a voltage or current to the defective cells.

The resistance is measured separately to the second electrode 150 through the supports 450. In this case, it is determined that defective cells are present when the measured resistance is 500Ω or less.

The repair of the defective cells is performed by burning or oxidizing metal components, which can degrade resistance characteristics, from the cells. This is done by applying a voltage of 3V to 12V to the supports 450 that are in contact with the defective cells or a current of 0.05A to 0.3A thereto for 1 second to 5 seconds.

In this configuration, the laser generating apparatus 300, the support 450, and the supporting plate 400 are integrally formed.

As set forth above, the support 450 can prevent the inverted substrate structure from sagging, measure each cell 200 for defects, and repair the defective cells, such that there is no need for separate inspection equipment, repair equipment, and/or substrate carrying equipment. In addition, an embodiment of the present invention can perform the inspection process and the repair process immediately after performing the laser patterning process, thereby shortening the time it takes to manufacture a solar cell module.

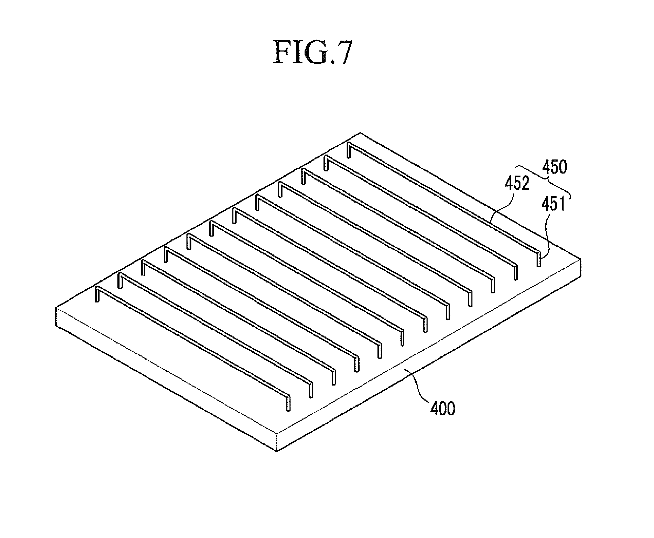

FIG. 7 is a diagram showing a support structure according to an embodiment of the present invention.

Referring to FIG. 7, the plurality of supports 450 are formed on the supporting plate 400. An individual support 450 includes vertical supporting members 451 vertically extending from the supporting plate 400 and a horizontal supporting member 452 extended horizontally and connected to the vertical supporting members 451 at each end of the member 452. The structure of the support 450 surface-contacts the second electrode 150 of each cell 200 along the horizontal supporting member 452, thereby preventing the sagging of the inverted substrate structure. In addition, the support 450 has conductivity and is made of a material that does not scratch the surface-contacted second electrode 150.

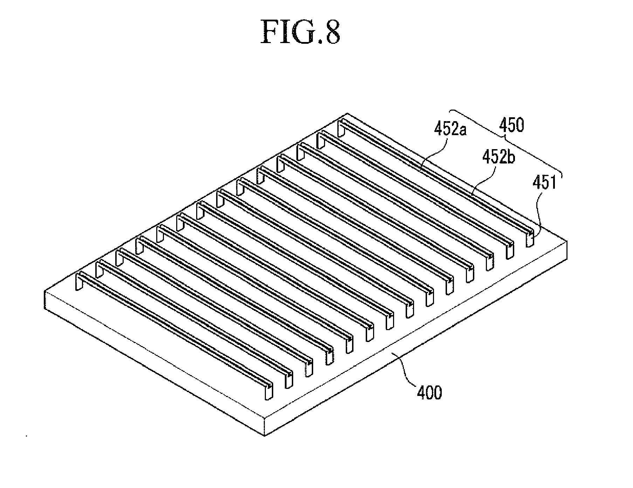

FIG. 8 is a diagram showing a support structure according to an embodiment of the present invention.

Referring to FIG. 8, the structure of the support shown in FIG. 8 is similar to the structure of the support shown in FIG. 7, but has a difference in that the horizontal supporting member includes a first horizontal supporting member 452a and a second horizontal supporting member 452b with a groove formed therebetween.

While the present invention has been described in detail with reference to the embodiments, those skilled in the art will appreciate that various modifications and substitutions can be made thereto without departing from the scope of the present invention as set forth in the appended claims.

## Claims

1. A method for manufacturing a solar cell module, comprising:
forming a first electrode layer on a first surface of a substrate;
forming a semiconductor layer on the first electrode;
forming a second electrode layer on the semiconductor layer;
inverting the substrate with the first electrode layer, semiconductor layer and second electrode layer formed thereon, and then, positioning the inverted substrate on a plurality of supports;
patterning the second electrode layer and the semiconductor layer while the inverted substrate is on the supports by irradiating a laser on a second surface of the substrate to form a plurality of solar cells, wherein the second surface of the substrate is opposite the first surface of the substrate;
identifying defective solar cells by using the supports; and optionally
repairing the defective solar cells by using the supports.

2. A method according to claim 1, wherein the supports are included on a supporting plate, and wherein each support includes first and second vertical supporting members vertically extending from the supporting plate and a horizontal supporting member having a first end connected to the first vertical supporting member and a second end connected to the second vertical supporting member.

3. A method according to claim 2, wherein each support contacts a surface of the second electrode layer of a solar cell.

4. A method according to any one of claims 1 to 3, wherein the defective solar cells are identified by measuring a resistance of each solar cell; optioanlly wherein the resistance measurement of a solar cell is made by using the support in contact with that solar cell and the support in contact with an adjacent solar cell; further optionally wherein a solar cell is defective if its measured resistance is 500Ω or less.

5. A method according to claim 4, wherein the defective cells are repaired by applying a current or voltage to the supports contacting the defective cells.

6. A method according to claim 5, wherein the defective cells are repaired by applying a voltage of 3V to 12V to the supports contacting the defective cells.

7. A method according to claim 5 or 6, wherein the defective cells are repaired by applying a current of 0.05A to 0.3A to the supports contacting the defective cells for 1 second to 5 seconds.

8. A method according to any one of claims 5 to 7, further comprising forming a first groove in the first electrode layer by patterning the first electrode layer;
optionally further comprising forming a second groove in the semiconductor layer by patterning the semiconductor layer.

9. A method according to claim 8, wherein the patterning of the first electrode layer forms a plurality of first electrodes, the patterning the semiconductor layer forms a plurality of semiconductor layer regions, the patterning the second electrode layer forms a plurality of second electrodes;
wherein each solar cell includes a said first electrode, a said semiconductor layer region and a said second electrode;
optionally wherein the second electrode of each solar cell contacts the first electrode of an adjacent solar cell via a corresponding second groove in the semiconductor layer.

10. A method according to claim 2 or any claim dependent on claim 2, wherein each support includes first and second said horizontal supporting members, wherein a groove is disposed between the first and second horizontal supporting members.

11. A method according to any one of claims 1 to 10, wherein the identification of the defective solar cells is performed immediately after the patterning of the second electrode layer and the semiconductor layer; optionally wherein the defective solar cells are repaired immediately after they are identified.

12. A laser apparatus, comprising:
a laser generator; and
an inspecting and repairing unit,
wherein the inspecting and repairing unit includes:
a supporting plate; and
a plurality of supports disposed on the supporting plate, wherein a support includes first and second vertical supporting members vertically extending from the supporting plate and a horizontal supporting member connecting the vertical supporting members, and
wherein the plurality of supports are arranged to receive a current or voltage through the supporting plate.

13. An apparatus according to claim 12, wherein the horizontal supporting member includes a first horizontal supporting member and a second horizontal supporting member with a space formed therebetween.

14. An apparatus according to claim 12 or 13, further comprising a space between the laser generator and the supports, the space being large enough to accommodate a solar cell module therebetween.
